(19) **Europäisches Patentamt / European Patent Office / Office européen des brevets**

(11) **EP 2 019 391 B1**

(12) **EUROPEAN PATENT SPECIFICATION**

(45) Date of publication and mention
of the grant of the patent:
**16.01.2013 Bulletin 2013/03**

(51) Int Cl.:
***G10L 21/02*** *(2013.01)*

(21) Application number: **08167418.6**

(22) Date of filing: **24.06.2003**

(54) **Audio decoding apparatus and decoding method and program**

Audiodecodierungsvorrichtung und -decodierungsverfahren und -programm

Appareil de décodage audio et procédé de décodage et programme

(84) Designated Contracting States:
**AT BE BG CH CY CZ DE DK EE ES FI FR GB GR
HU IE IT LI LU MC NL PT RO SE SI SK TR**

(30) Priority: **19.07.2002 JP 2002210945
19.09.2002 JP 2002273010**

(43) Date of publication of application:
**28.01.2009 Bulletin 2009/05**

(62) Document number(s) of the earlier application(s) in
accordance with Art. 76 EPC:
**03765275.7 / 1 439 524**

(73) Proprietors:
• **NEC Corporation
Minato-ku
Tokyo 108-8001 (JP)**
• **Panasonic Corporation
Kadoma-shi
Osaka (JP)**

(72) Inventors:
• **Nomura, Toshiyuki
Minato-ku, Tokyo 108-8001 (JP)**

• **Shimada, Osamu
Minato-ku, Tokyo 108-8001 (JP)**
• **Takamizawa, Yuichiro
Minato-ku, Tokyo 108-8001 (JP)**
• **Serizawa, Masahiro
Minato-ku, Tokyo 108-8001 (JP)**
• **Tanaka, Naoya
Osaka 540-6207 (JP)**
• **Tsushima, Mineo
Osaka 540-6207 (JP)**
• **Norimatsu, Takeshi
Kita-ku, Kobe-shi, Hyogo 651-1305 (JP)**
• **Chong, Kok Seng
689527 Singapore (SG)**
• **Kuah, Kim Hann
760145 Singapore (SG)**
• **Neo, Sua Hong
Singapore 534415 (SG)**

(74) Representative: **Vossius & Partner
Siebertstrasse 4
81675 München (DE)**

(56) References cited:
**EP-A- 0 940 015     US-A1- 2002 087 304**

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

**Description**

TECHNICAL FiELD

The present invention relates to an audio decoding apparatus and decoding method for decoding a coded audio signal.

BACKGROUND ART

MPEG-2 AAC (Advanced Audio Coding) which is an international standard process of ISC/IEG is widely known as an audio coding/decoding process for coding an audio signal with high sound quality at a low bit rate. According to conventional audio coding/decoding processes that are typified by the MPEG-2 AAC, a plurality of samples from a time-domain PCM signal are put together into a frame, which is converted into a frequency-domain signal by a mapping transform such as MDCT (Modified Discrete Cosine Transform). The frequency-domain signal is then quantized and subjected to Huffman coding to produce a bit stream. For quantizing the frequency-domain signal, in view of the hearing characteristics of the human being, the quantizing accuracy is increased for more perceptible frequency components of the frequency-domain signal and reduced for less perceptible frequency components of the frequency-domain signal, thus achieving a high sound-quality level with a limited amount of coding. For example, a bit rate of about 96 kbps according to the MPEG-2 AAC can provide the same sound-quality level (at a sampling frequency of 44.1 kHz for a stereophonic signal) as CDs.

If a stereophonic signal, sampled at a sampling frequency of 44.1 kHz is coded at a lower bit rate, e.g., a bit rate of about 48 kbps, then efforts are made to maximize the subjective sound quality at the limited bit rate by not coding high-frequency components that are of less auditory importance, i.e., by setting their quantized values to zero. However, since the high-frequency components are not coded, the sound-quality level is deteriorated, and the reproduced sound is generally of muffled nature.

Attention has been drawn to the band expansion technology for solving the problem of the sound quality deterioration at low bit rates. According to the band expansion technology, a high-frequency bit stream as auxiliary information in a slight amount of coding (generally several kbps) is added to a low-frequency bit stream representative of an audio signal that has been coded at a low bit rate by a coding process such as the MPEG-2 AAC process or the like, thus producing a combined bit stream. The combined bit stream is decoded by an audio decoder as follows: The audio decoder decodes the low-frequency bit stream according to a decoding process such as the MPEG-2 AAC process or the like, producing a low-frequency audio signal that is free of high-frequency components. The audio decoder then processes the low-frequency audio signal based on the auxiliary information represented by the high-frequency bit stream according to the band expansion technology, thus generating high-frequency components. The high-frequency components thus generated and the low-frequency audio signal produced by decoding the low-frequency bit stream are combined into a decoded audio signal that contains the high-frequency components.

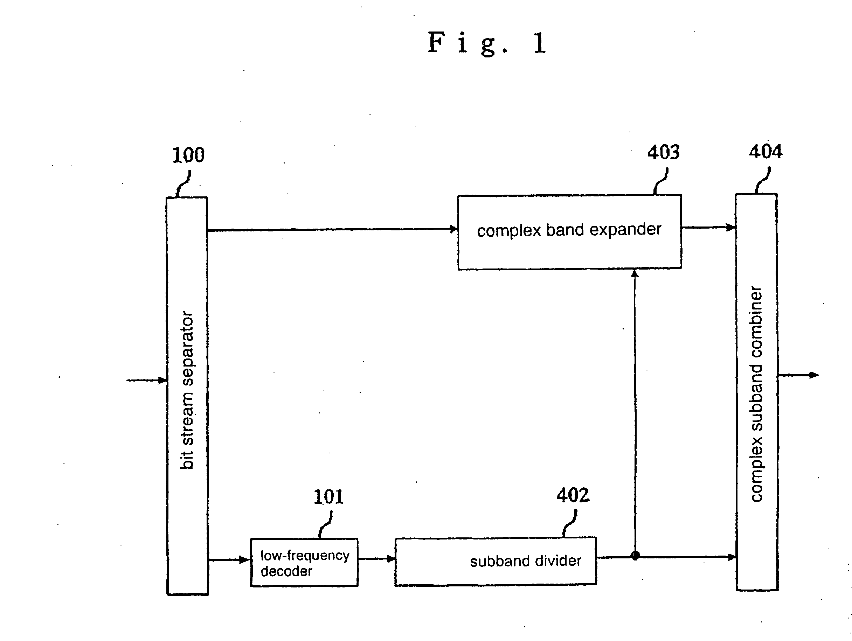

One example of a conventional audio decoder based on the band expansion technology is a combination of an MPEG-2 AAC decoder and a band expansion technology called SBR as described in document 1, section 5.6 shown below. Fig. 1 of the accompanying drawings illustrates a conventional audio decoder based on the band expansion technology described in document 1.

Document 1: "Digital Radio Mondiale (DRM); System Specification" (ETSI TS 101 980 V1. 1.1), published September, 2001, p. 42 - 57.

The conventional audio decoder shown in Fig. 1 comprises bit stream separator 100, low-frequency decoder 101, subband divider 402, complex band expander 403, and complex subband combiner 404.

Bit stream separator 100 separates an input bit stream and outputs separated bit streams to low-frequency decoder 101 and complex band expander 403. Specifically, the input bit stream comprises a multiplexed combination of a low-frequency bit stream representing a low-frequency signal that has been coded by a coding process such as the MPEG-2 AAC process and a high-frequency bit stream including information that is required for complex band expander 403 to generate a high-frequency signal. The low-frequency bit stream is output to low-frequency decoder 101, and the high-frequency bit stream is output to complex band expander 403.

Low-frequency decoder 101 decodes the input low-frequency bit stream into a low-frequency audio signal, and outputs the row-frequency audio signal to subband divider 402. Low-frequency decoder 101 decodes the input low-frequency bit stream according to an existing audio decoding process such as the MPEG-2 AAC process or the like.

Subband divider 402 has a complex subband dividing filter that divides the input low-frequency bit stream into a plurality of low-frequency subband signals in respective frequency bands, which are output to complex band expander 403 and complex subband combiner 404. The complex subband dividing filter may comprise a 32-band complex QMF (Quadrature Mirror Filter) bank which has heretofore been widely known in the art. The complex low-frequency subband signals divided in the respective 32 subbands are output to complex band expander 403 and complex subband combiner 404. The 32-band complex QFF bank processes the input low-frequency bit stream according to the following equation:

$$X_k(m) = \sum_{n=-\infty}^{\infty} h(mM-n)x(n)\, W_{K1}^{-(k+k_0)(n+n_0)}, k=0,1,...,K1-1 \qquad 402.1$$

$$W_{K1} = e^{j\frac{2\pi}{K1}} \qquad\qquad 402.2$$

where x(n) represents the low-frequency audio signal, Xk(m) the kth-band low-frequency subband signal, and h(n) the analytic low-pass filter. In this example, K1 = 64.

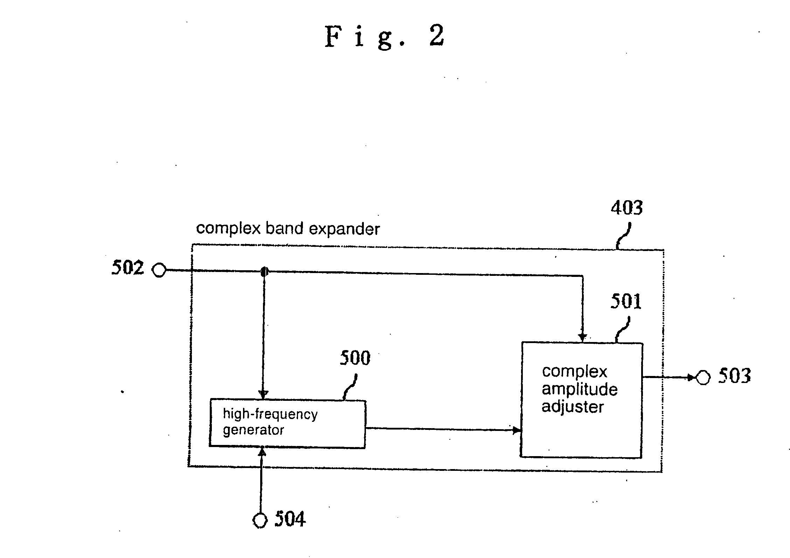

Complex band expander 403 generates a high-frequency subband signal representing a high-frequency audio signal from the high-frequency bit stream and the low-frequency subband signals that have been input thereto, and outputs the generated high-frequency subband signal to complex subband combiner 404. As shown in Fig. 2 of the accompanying drawings, complex band expander 403 comprises complex high-frequency generator 500 and complex amplitude adjuster 501. Complex band expander 403 is supplied with the high-frequency bit stream from input terminal 502 and with the tow-frequency subband signals from input terminal 504, and outputs the high-frequency subband signal from output terminal 503.

Complex high-frequency generator 500 is supplied with the low-frequency subband signals and the high-frequency bit stream, and copies the signal in the subband that is specified among the low-frequency subband signals by the high-frequency bit stream, to a high-frequency subband. When copying the signal, complex high-frequency generator 500 may perform a signal processing process specified by the high-frequency bit stream. For example, it is assumed that there are 64 subbands ranging from subband 0 to subband 63 in the ascending order of frequencies, and complex subband signals from subband 0 to subband 19, of those 64 subbands, are supplied as the low-frequency subband signals to input terminal 504. It is also assumed that the high-frequency bit stream contains copying information indicative of which one of the low-frequency subbands (subband 0 to subband 19) a signal is to be copied from to generate a subband A (A > 19), and signal processing information representing a signal processing process (selected from a plurality of processes including a filtering process) to be performed on the signal. In complex high-frequency generator 500, a complex-valued signal in a high-frequency subband (referred to as "copied/processed subband signal") is identical to a complex-valued signal in a low-frequency subband indicated by the copying information. If the signal processing information indicates any signal processing need for better sound quality, then complex high-frequency generator 500 performs the signal processing process indicated by the signal processing information on the copied/processed subband signal. The copied/processed subband signal thus generated is output to complex amplitude adjuster 501.

One example of signal, processing performed by complex high-frequency generator 500 is a linear predictive inverse filter that is generally well known for audio coding. Generally, it is known that the filter coefficients of a linear predictive inverse filter can be calculated by linearly predicting an input signal, and the linear predictive inverse filter using the filter coefficients operate to whiten the spectral characteristics of the input signal. The reason why the linear predictive inverse filter is used for signal processing is to make the spectral characteristics of the high-frequency subband signal flatter than the spectral characteristics of the low-frequency subband signal from which it is copied. A comparison between the spectral characteristics of low- and high-frequency subband signals of an audio signal, for example, indicates that the spectral characteristics of the high-frequency subband signal are often flatter than the spectral characteristics of the low-frequency subband signal. Therefore, a high-quality band expansion technology can be realized by using the above flattening technique.

Complex amplitude adjuster 501 performs a correction specified by the high-frequency bit stream on the amplitude of the input copied/processed subband signal, generating a high-frequency subband signal. Specifically, complex amplitude adjuster 501 performs an amplitude correction on the copied/processed subband signal in order to equalize the signal energy (referred to as "target energy") of high-frequency components of the input signal on the coding side and the high-frequency signal energy of the signal generated by complex band expander 403 with each other. The high-frequency bit stream contains information representative of the target energy. The generated high-frequency subband signal is output to output terminal 503. The target energy described by the high-frequency bit stream may be considered as being calculated in the unit of a frame for each subband, for example. Alternatively, in view of the characteristics in the time and frequency directions of the input signal, the target energy may be calculated in the unit of a time divided from a frame with respect to the time direction and in the unit of a band made up of a plurality of subbands with respect to the frequency direction, If the target energy is calculated in the unit of a time divided from a frame with respect to the time direction, then time-dependent changes in the energy can be expressed in further detail. If the target energy is calculated in the unit of a band made up of a plurality of subbands with respect to the frequency direction, then the number of bits required to code the target energy can be reduced. The unit of divisions in the time and frequency directions used for calculating the target energy is represented by a time frequency grid, and its information is described by the high-frequency bit stream.

According to another arrangement of complex amplitude adjuster 501, an additional signal is added to the Copied/prrocessed subband signal, generating a high-frequency subband signal. The amplitude of the copied/processed subband signal and the amplitude of the additional signal are adjusted such that the energy of the high-frequency subband signal serves as a target energy. An example of the additional signal is a noise signal or a tone signal. Gains for adjusting the amplitudes of the copied/processed subband signal and the additional signal, on the assumption that either one of the copied/processed subband signal and the additional signal serves as a main component of the generated high-frequency subband signal, and the other as an auxiliary component thereof, are calculated as follow: if the copied/processed subband signal serves as a main component of the generated high-frequency subband signal, then

$$\text{Gmain} = \text{sqrt}(R/E/(1 + Q))$$

$$\text{Gsub} = \text{sqrt}(R \times Q/N/(1 + Q))$$

where Gmain represents the gain for adjusting the amplitude of the main component, Gsub the gain for adjusting the amplitude of the auxiliary component, and E, N the respective energies of the copied/processed subband signal and the additional signal. If the energy of the additional signal is normalized to 1, then N = 1. In the above equations, R represents the target energy, Q the ratio of the energies of the main and auxiliary components, R, Q being described by the high-frequency bit stream, and sqrt() the square root. If the additional signal serves as a main component of the generated high-frequency subband signal, then

$$\text{Gmain} = \text{sqrt}(R/N/(1 + Q))$$

$$\text{Gsub} = \text{sqrt}(R \times Q/E/(1 + Q))$$

The high-frequency subband signal, can be calculated by weighting the copied/processed subband signal and the additional signal using the amplitude adjusting gains thus calculated and adding the copied/processed subband signal and the additional signal which are thus weighted.

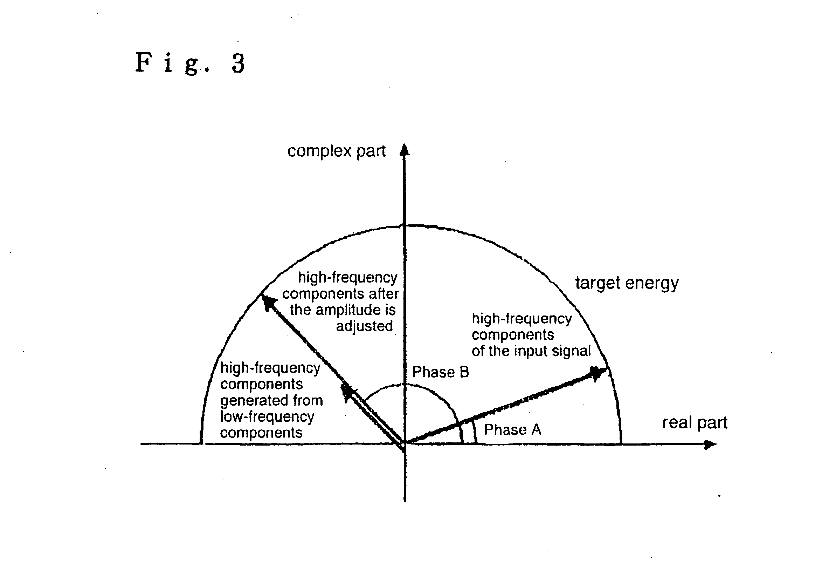

Operation of complex amplitude adjuster 501 for amplitude adjustment and advantages thereof will be described in detail with reference to Fig. 3. The signal phase (phase A in Fig. 3) of high-frequency components of the input signal on the coding side and the signal phase (phase B in Fig. 3) of the high-frequency subband signal derived from the low-frequency subband signal are entirely different from each other as shown in Fig. 3. However, since the amplitude of the high-frequency subband signal is adjusted such that its signal energy is equalized to the target energy, the sound quality as it is heard is prevented from being degraded. This is because the human auditory sense is more sensitive to signal energy variations than to signal phase variations.

Complex subband combiner 404 has a complex subband combining filter that combines the bands of the low-frequency subband signal and the high-frequency subband signal that have been input thereto. An audio signal generated by combining the bands is output from the audio decoder. The complex subband combining filter that is used corresponds to the complex subband dividing filter used in subband divider 402. That is, these filters are selected such that a certain signal is divided by a complex subband dividing filter into subband signals, which are combined by a complex subband combining filter to fully reconstruct the original signal (the signal input to the complex subband dividing filter). For example, if the 32-band complex QMF dividing filter bank (K1 = 64) represented by the equation 402.1 is used as the complex subband combining filter, then the following equation 404.1 can be employed:

$$x(n) = \sum_{m=-\infty}^{\infty} f(n - mM)\frac{1}{K2} \sum_{k=0}^{K2-1} X_k(m) W_{K2}^{(k+k_0)(n+n_0)} \qquad 404.1$$

where f(n) represents the combining low-pass filter, In this example, K2 = 64.

If the sampling frequency for the audio signal output from complex subband combiner 404 is higher than the sampling frequency for the audio signal output from low-trequency decoder 101 according to the band expansion technology, then the filters are selected such that a low-frequency part (down-sampled result) of the audio signal output from complex subband combiner 404 is equal to the audio signal output from low-frequency decoder 101. Complex subband combiner 404 may employ a 64-band complex QMF combining filter bank (K2 = 128 in the equation 404.1). In this case, the lower-frequency 32 bands employ the output of a 32-band complex QMF combining filter bank as a signal value.

The conventional audio decoder has been problematic in that it has a subband divider and a complex subband combiner which require a large amount of calculations, and the required amount of calculations and the apparatus scale are large because the band expansion process is carried out using complex numbers.

EP-A-0 940 015 describes a source coding enhancement method using spectral-band replication. US 2002/0087304 A1 describes a method for enhancing audio source coding systems utilizing high frequency reconstruction, wherein adaptive filtering is used to reduce artifacts due to different tonal characteristics in different frequency ranges of an audio signal, upon which high frequency reconstruction is performed. WO 03/046891 A1 describes a method and an apparatus for enhancing audio source coding systems utilizing high frequency reconstruction, wherein the apparatus uses a detection mechanism on the encoder side to assess what parts of the spectrum will not be correctly produced by the high frequency reconstruction method.

## DISCLOSURE OF THE INVENTION

It is an object of the present invention to provide a band expansion technique for maintaining high sound quality and reducing an amount of calculations required, and an audio decoding apparatus, an audio decoding method, and an audio decoding program which employ such a band expansion technique. This object of the present invention is achieved with the features of the claims.

An audio decoding apparatus of the present invention is defined in claim 1. An audio decoding method of the present invention is defined in independent claim 4. A program according to the present invention is defined in independent claim 21. Further preferred embodiments of the invention are defined in the dependent claims.

## BRIEF DESCRIPTION OF THE DRAWINGS

Fig. 1 is a block diagram showing an arrangement of a conventional audio decoder;
Fig. 2 is a block diagram of complex band expander 403 of the conventional audio decoder;
Fig. 3 is a diagram illustrative of an amplitude adjustment process according to the conventional audio decoder;
Fig. 4 is a diagram illustrative of an amplitudes adjustment process according to the present invention;
Fig. 5 is a diagram illustrative of an amplitude adjustment process without energy correction;
Fig. 6 is a block diagram of an audio decoding apparatus according to a first embodiment of the present invention;
Fig. 7 is a block diagram of an audio decoding apparatus according to a second embodiment of the present invention; and
Fig. 8 is a block diagram of band expander 103 according to the present invention.

## BEST MODE FOR CARRYING OUT THE INVENTION

Embodiments of the present invention will be described in detail below with reference to the drawings.

(1 st Embodiment)

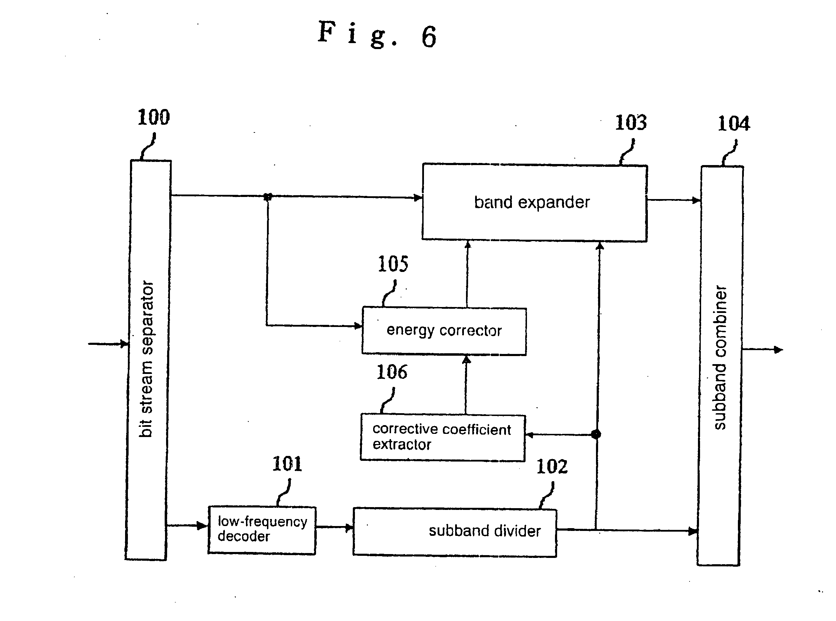

Fig. 6 is a block diagram of an audio decoding apparatus according to a first embodiment of the present invention. The audio decoding apparatus according to the present embodiment comprises bit stream separator 100, low-frequency decoder 101, subband divider 102, band expander 103, subband combiner 104, energy corrector 105, and corrective coefficient extractor 106.

Bit stream separator 100 separates an input bit stream and outputs separated bit streams to low-frequency decoder 101, band expander 103, and energy corrector 105. Specifically, the input bit stream comprises a multiplexed combination of a low-frequency bit stream representing a low-frequency signal that has been coded and a high-frequency bit stream including information that is required for band expander 103 to generate a high-frequency signal. The low-frequency bit stream is output to low-frequency decoder 101, and the high-frequency bit stream is output to band expander 103 and energy corrector 105.

Low-frequency decoder 101 decodes the input low-frequency bit stream into a low-frequency audio signal, and outputs the low-frequency audio signal to subband divider 102. Low-frequency decoder 101 decodes the input low-frequency bit stream according to an existing audio decoding process such as the MPEG-2 AAC process or the like.

Subband divider 102 has a complex subband dividing filter that divides the input low-frequency bit stream into a plurality of low-frequency subband signals in respective frequency bands, which are output to band expander 103, subband combiner 104, and corrective coefficient extractor 106.

Corrective coefficient extractor 106 calculates an energy corrective coefficient from the low-frequency subband signal according to a process to be described later on, and outputs the calculated energy corrective coefficient to energy corrector 105.

Energy corrector 105 corrects a target energy for high-frequency components which is described by the high-frequency bit stream that is input thereto, according to the energy corrective coefficient, thus calculating a corrected target energy, and outputs the corrected target energy to band expander 103.

Band expander 103 generates a high-frequency subband signal representing a high-frequency audio signal from the high-frequency bit stream, the low-frequency subband signal, and the corrected target energy that have been input thereto, and outputs the generated high-frequency subband signal to subband combiner 104.

Subband combiner 104 has a subband combining filter that combines the bands of the low-frequency subband signal and the high-frequency subband signal that have been input thereto. An audio signal generated by combining the bands is output from the audio decoding apparatus.

The audio decoding apparatus according to the present invention which is arranged as described above is different from the conventional audio decoder shown in Fig. 1 in that the audio decoding apparatus according to the present invention has subband divider 102 shown in Fig. 6 instead of subband divider 402 shown in Fig. 1, subband combiner 104 shown in Fig. 6 instead of subband combiner 404 shown in Fig. 1, band expander 103 shown in Fig. 6 instead of complex band expander 403 shown in Fig. 1, and additionally has corrective coefficient extractor 106 and energy corrector 105 according to the present embodiment (Fig. 6). Other processing components will not be described in detail below because they are the same as those of the conventional audio decoder, well known by those skilled in the art, and have no direct bearing on the present invention. Subband divider 102, band expander 103, subband combiner 104, energy corrector 105, and corrective coefficient extractor 106 which are different from the conventional audio decoder will be described in detail below.

First, subband divider 102 and subband combiner 104 will be described below. Heretofore, a filter bank according to the equation 402.1 for generating a complex subband signal has been used as a subband dividing filter. For a corresponding inverse conversion, a filter bank according to the equation 404.1 has been used as a subband combining filter. The output of the equation 404.1 or a signal produced by down-sampling the output of the equation 404.1 at the sampling frequency for the input signal of the equation 402.1 is fully reconstructible in full agreement with the input signal of the equation 402.1. In order to obtain a high-quality decoded audio signal, such full reconstructibility is required for the subband dividing and combining filters.

In the present embodiment, the complex subband combining filter used in conventional complex subband combiner 404 is replaced with a real subband combining filter, However, simply changing a complex subband combining filter to a real subband combining filter will lose full reconstructibility, resulting in a sound quality deterioration,

In has heretofore been well known in the art to effect rotational calculations on the output of the conventional complex subband dividing filter for achieving full reconstructibility between a complex subband combining filter and a real subband combining fitter. Such rotational calculations serve to rotate the real and imaginary axes of a complex number by $(\pi \div 4)$, and are the same as a well known process of deriving DCT from DFT. For example, if k0 = 1/2, then the following rotational calculations (K = K1) may be performed on each subband k for calculating the 32-band complex QMF dividing filter bank according to the equation 402.1:

$$W_K^{-(k+k_0)\frac{3}{4}K} \qquad\qquad 102.1$$

In the equation 102.1, 3/4K may be replaced with 1/4K.

Conventional subband divider 402 with a processor for performing the rotational calculations according the equation 102.1 being added at a subsequent stage may be employed as subband divider 102. However, subband divider 102 may calculate the following equation which can achieve, with a smaller amount of calculations, a process that is equivalent to the process comprising the subband dividing filtering and the rotational calculation processing:

$$X_k(m) = \sum_{n=-\infty}^{\infty} h(mM - n)x(n) W_{K1}^{-(k+k_0)(n+n_0-\frac{3}{4}K1)}, k = 0,1,...,K1-1 \quad 102.2$$

The conversion represented by the equation 144.1, shown below, is effected on the equation 404.1, and the equation 144.2, shown below, representing only a real part thereof is used as a corresponding real subband combining filter in subband combiner 104. In this manner, full reconstructibility is achieved.

$$W_K^{(k+k_0)\frac{3}{4}K} \qquad\qquad 104.1$$

$$x(n) = \sum_{m=-\infty}^{\infty} f(n - mM)\frac{2}{K2} \sum_{k=0}^{K2-1} \text{Re}[X_k(m)]\cos(\frac{2\pi}{K2}(n + n_0)(k + k_0 + \frac{3}{4}K2))$$

$$104.2$$

where Re[.] represents the extraction of only the real part of a complex subband signal.

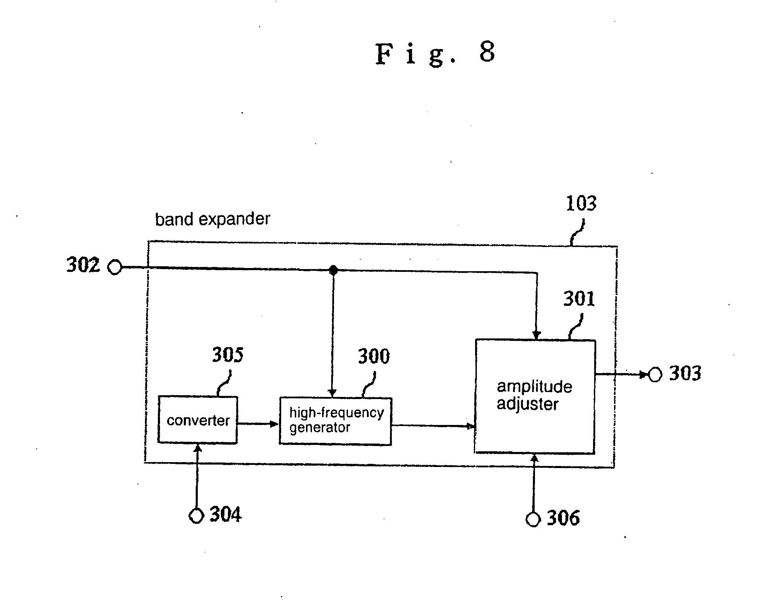

Band expander 103 will be described below. Band expander 103 generates a high-frequency subband signal representing a high-frequency audio signal from the high-frequency bit stream, the low-frequency subband signals, and the corrected target energy that have been input thereto, and outputs the generated high-frequency subband signal to subband combiner 104. As shown in Fig. 8, band expander 103 comprises high-frequency generator 300, amplitudes adjuster 301, and converter 305. Band expander 103 is supplied with the high-frequency bit stream from input terminal 302, the low-frequency subband signals from input terminal 304, and the corrected target energy from input terminal 306, and outputs the high-frequency subband signal from output terminal 303.

Converter 305 extracts only the real parts from the complex low-frequency subband signals input from input terminal 304, converts the extracted real parts into real low-frequency subband signals (the low-frequency subband signals are hereafter shown in terms of a real number unless indicated otherwise), and outputs the real low-frequency subband signals to high-frequency generator 300.

High-frequency generator 300 is supplied with the low-frequency subband signals and the high-frequency bit stream, and copies the signal in the subband that is specified among the low-frequency subband signals by the high-frequency bit stream, to a high-frequency subband. When copying the signal, high-frequency generator 300 may perform a signal processing process specified by the high-frequency bit stream. For example, it is assumed that there are 64 subbands ranging from subband 0 to subband 63 in the descending order of frequencies, and real subband signals from subband 0 to subband 19, of those 64 subbands, are supplied as the low-frequency subband signals from converter 305. It is also assumed that the high-frequency bit stream contains copying information indicative of which one of the low-frequency subbands (subband 0 to subband 19) a signal is to be copied from to generate a subband A (A > 19), and signal processing information representing a signal processing process (selected from a plurality of processes including a filtering process) to be performed on the signal. In high-frequency generator 300, a real-valued signal in a high-frequency subband (referred to as "copied/processed subband signal") is identical to a real-valued signal in a low-frequency subband indicated by the copying information. If the signal processing information indicates any signal processing need for better sound quality, then high-frequency generator 300 performs the signal processing process indicated by the signal processing information on the copied/processed subband signal. The copied/processed subband signal thus generated is output to amplitude adjuster 301.

One example of signal processing performed by high-frequency generator 300 is a linear predictive inverse filter as with conventional complex high-frequency generator 500. The effect of such a filter will not be described below as it is the same as with complex high-frequency generator 500. If a linear predictive inverse filter is used for a high-frequency generating process, then high-frequency generator 300 that operates with real-valued signals is advantageous in that the amount of calculations required to calculate filter coefficients is smaller than it would be with complex high-frequency generator 500 that operates with complex-valued signals,

Amplitude adjuster 301 performs a correction specified by the high-frequency bit stream on the amplitude of the input copied/processed subband signal so as to make it equivalent to the corrected target energy, generating a high-frequency subband signal. The generated high-frequency subband signal is output to output terminal 303. The target energy described by the high-frequency bit stream may be considered as being calculated in the unit of a frame for each subband, for example. Alternatively, in view of the characteristics in the time and frequency directions of the input signal, the target energy may be calculated in the unit of a time divided from a frame with respect to the time direction and in the unit of a band made up of a plurality of subbands with respect to the frequency direction. If the target energy is calculated in the unit of a time divided from a frame with respect to the time direction, then time-dependent changes in the energy can be expressed in further detail. If the target energy is calculated in the unit of a band made up of a plurality of subbands with respect to the frequency direction, then the number of bits required to code the target energy can be reduced. The unit of divisions in the time and frequency directions used for calculating the target energy is represented by a time frequency grid, and its information is described by the high-frequency bit stream.

According to the embodiment of amplitude adjuster 301, as with the conventional arrangement, an additional signal is added to the copied/processed subband signal, generating a high-frequency subband signal. The amplitude of the copied/processed subband signal and the amplitude of the additional signal are adjusted such that the energy of the high-frequency subband signal serves as a target energy. An example of the additional signal is a noise signal or a tone signal. Gains for adjusting the amplitudes of the copied/processed subband signal and the additional signal, on the assumption that either one of the copied/processed subband signal and the additional signal serves as a main component of the generated high-frequency subband signal, and the other as an auxiliary component thereof, are calculated as follows: If the copied/processed subband signal serves as a main component of the generated high-frequency subband signal, then

$$Gmain = sqrt(a \times R/Er/(1 + Q))$$

$$Gsub = sqrt(a \times R \times Q/Nr/(1 + Q))$$

where Gmain represents the gain for adjusting the amplitude of the main component, Gsub the gain for adjusting the amplitude of the auxiliary component, and Er, Nr the respective energies of the copied/processed subband signal and the additional signal. The notations Er, Nr of the energies are different from the notations E, N in the description of the conventional arrangement in order to differentiate the real-valued signals used as the copied/processed subband signal and the additional signal according to the present invention from the complex-valued signals used as the copied/processed subband signal and the additional signal according to the conventional arrangement. If the energy of the additional signal is normalized to 1, then Nr = 1. In the above equations, R represents the target energy, "a" the energy corrective coefficient that is calculated by corrective efficient extractor 106 to be described later on, with a x R representing the corrected target energy, Q the ratio of the energies of the main and auxiliary components, R, Q being described by the high-frequency bit stream, and sqrt() the square root. If the additional signal serves as a main component of the generated high-frequency subband signal, then

$$Gmain = sqrt(a \times R/Nr/(1 + Q))$$

$$Gsub = sqrt(a \times R \times Q/Er/(1 + Q))$$

If the additional signal serves as a main component of the generated high-frequency subband signal, then Gmain, Gsub may be indicated by the following equations, using an energy corrective coefficient "b" calculated based on the additional signal according to the same process as with the energy corrective coefficient "a", instead of the energy corrective coefficient "a" calculated based on the complex low-frequency subband signals:

$$Gmain = sqrt(b \times R/Nr/(1 + Q))$$

$$Gsub = sqrt(b \times R \times Q/Er/(1 + Q))$$

If a signal stored in advance in a memory area is used as the additional signal, then the energy corrective coefficient "b" may be calculated in advance and used as a constant, so that a process for calculating the energy corrective coefficient "b" may be dispensed with. The high-frequency subband signal can be calculated by weighting the copied/processed subband signal and the additional signal using the amplitude adjusting gains thus calculated and adding the copied/processed subband signal and the additional signal which are thus weighted.

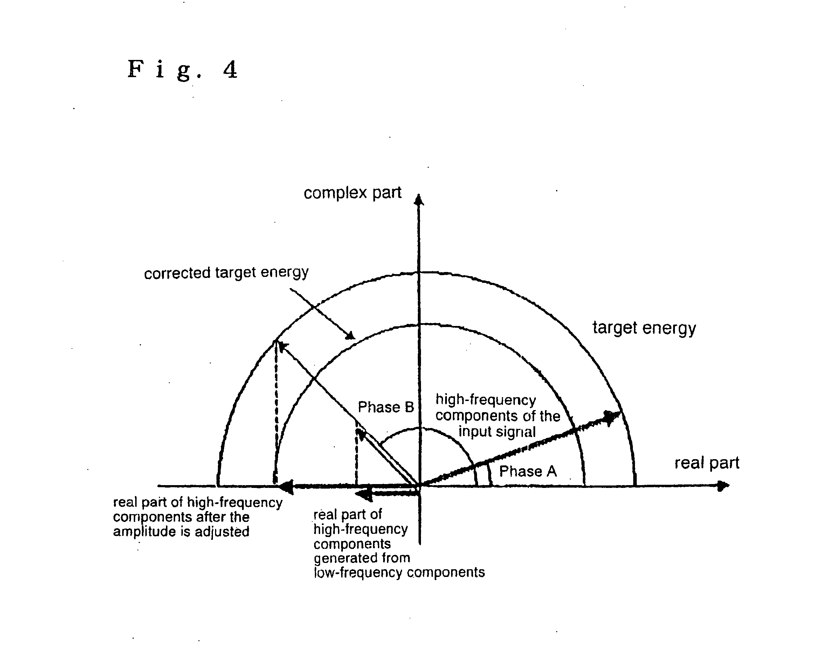

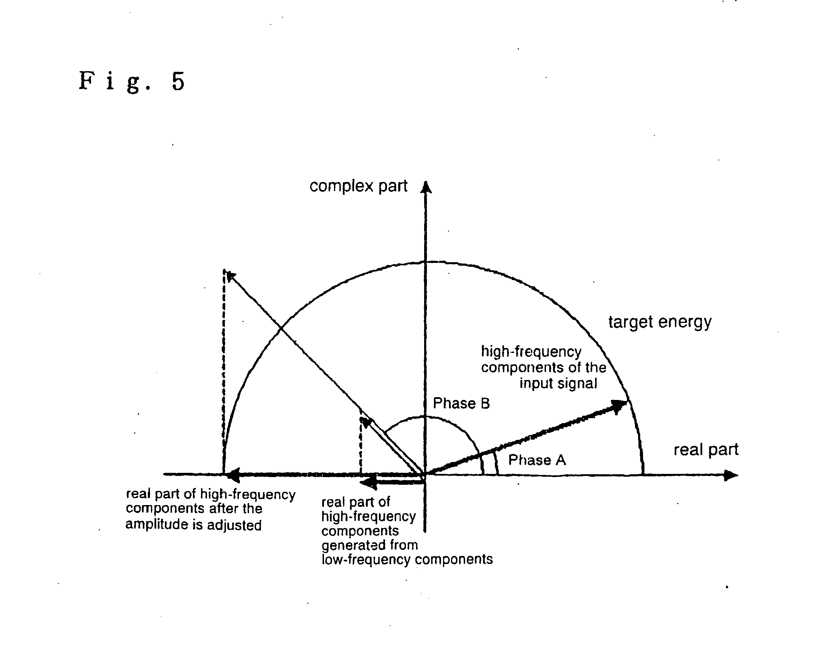

Operation of amplitude adjuster 301 for amplitude adjustment and advantages thereof will be described in detail with reference to Fig. 4. The amplitude of the real high-frequency subband signal (the real part of the high-frequency components whose amplitudes have been adjusted in Fig. 4) is adjusted such that its signal energy is equalized to the corrected target energy which is obtained by correcting the target energy representative of the signal energy of high-frequency components of the input signal. If the corrected target energy is calculated in view of the signal phase (phase B in Fig. 4) of the complex low-frequency subband signal before the corrected target energy is converted by converter 305, as shown in Fig. 4, then the signal energy of a hypothetical complex high-frequency subband signal derived from the complex low-frequency subband signal is equivalent to the target energy. In an analytic combining system comprising subband divider 102 and subband combiner 104 used in the present embodiment, full reconstructibility is obtained using only the real part of the subband signal, as when both the real part and the imaginary part are used. Therefore, when the amplitude of the real high-frequency subband signal is adjusted such that its signal energy is equalized to the corrected target energy, energy variations important for the human auditory sense are minimized, the sound quality as it is heard is prevented from being degraded. An example in which the amplitude is adjusted using the target energy, rather than the corrected target energy, is shown in Fig. 5. As shown in Fig. 5, if the amplitude of the real high-frequency subband signal is adjusted such that its signal energy is equalized to the corrected target energy, then the signal energy of the hypothetical complex high-frequency subband signal becomes greater than the target energy. As a result, the high-frequency components of the audio signal whose bands have been combined by subband combiner 104 are greater than the high-frequency components of the input signal on the coding side, resulting in a sound quality deterioration.

Band expander 103 has been described above. In order to realize the processing of band expander 103 only with the real part in a low amount of calculations and to obtain a high-quality decoded signal, it is necessary to employ the corrected target energy for amplitude adjustment, as described above. In the present embodiment, corrective coefficient extractor 106 and energy corrector 105 calculate the corrected target energy.

Corrective coefficient extractor 106 calculates an energy corrective coefficient based on the complex low-frequency subband signal that has been input, and outputs the calculated energy corrective coefficient to energy corrector 105. An energy corrective coefficient can be calculated by calculating the signal phase of the complex low-frequency subband signal and using the calculated signal phase as the energy corrective coefficient. For example, the energy of a low-frequency subband signal comprising complex-valued signal samples and the energy calculated from the real part thereof may be calculated, and the ratio of these energies may be used as an energy corrective coefficient. Alternatively, the phases of respective complex-valued signal sample values of a low-frequency subband signal may be calculated and averaged into an energy corrective coefficient. According to the process described above, an energy corrective coefficient is calculated for each of the divided frequency bands. The energy corrective coefficients of adjacent frequency bands and the energy corrective coefficient of a certain frequency band may be smoothed and used as the energy corrective coefficient of the certain frequency band, Alternatively, the energy corrective coefficient of a present frame may be smoothed in the time direction using a predetermined time constant and the energy corrective coefficient of a preceding frame. By thus smoothing the energy corrective coefficient, the energy corrective coefficient can be prevented from changing abruptly, with the result that the audio signal whose band has been expanded will be of increased quality.

The energy may be calculated or the phases of signal sample values may be averaged according to the above process, using signal samples contained in the time frequency grid of target energies which has been described above with respect to the conventional arrangement. In order to increase the quality of the audio signal whose band has been expanded, it is necessary to calculate an energy corrective coefficient which is accurately indicative of phase characteristics. To meet such a requirement, it is desirable to calculate an energy corrective coefficient using signal samples whose phase characteristics have small changes. Generally, the time frequency grid is established such that signal changes in the grid are small. Consequently, by calculating an energy corrective coefficient in accordance with the time frequency grid, it is possible to calculate an energy corrective coefficient which is accurately indicative of phase characteristics, with the result that the audio signal whose band has been expanded will be of increased quality. The present process may be carried out, taking into account signal changes in either one of the time direction and the frequency direction, and using signals samples included in a range that is divided by only a grid boundary in either one of the time direction and the frequency direction.

Energy corrector 105 corrects the target energy representative of the signal energy of high-frequency components of the input signal which is described by the high-frequency bit stream, with the energy corrective coefficient calculated by corrective coefficient extractor 106, thus calculating a corrected target energy, and outputs the corrected target energy to band expander 103.

(2nd Embodiment)

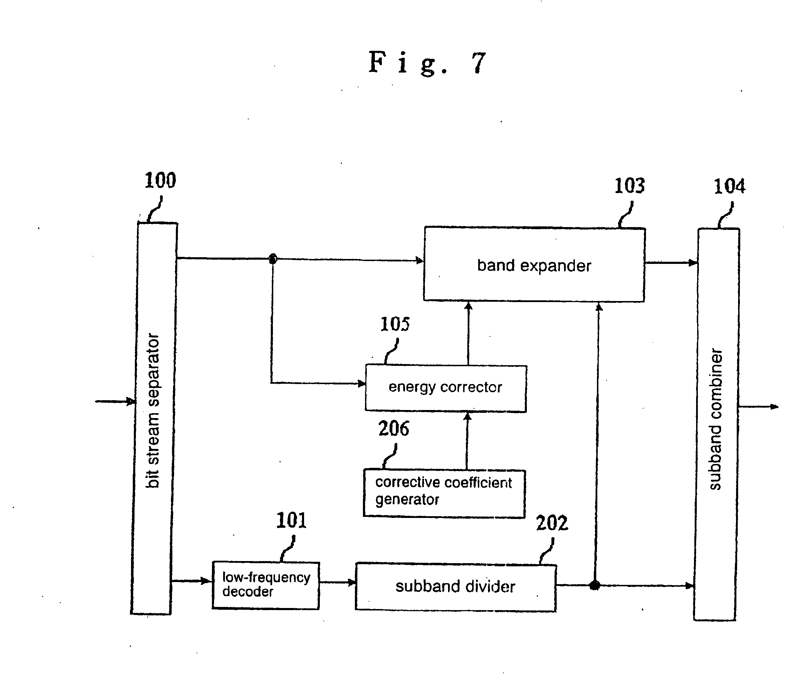

A second embodiment of the present invention will be described in detail below with reference to Fig. 7.

Fig. 7 shows an audio decoding apparatus according to the second embodiment of the present invention. The audio decoding apparatus according to the present embodiment comprises bit stream separator 100, low-frequency decoder 101, subband divider 202, band expander 103, subband combiner 104, corrective coefficient generator 206, and energy corrector 105.

The second embodiment of the present invention differs from the first embodiment of the present invention in that subband divider 102 is replaced with subband divider 202, and corrective coefficient extractor 106 is replaced with corrective coefficient generator 206, and is exactly identical to the first embodiment as to the other components. Subband divider 202 and corrective coefficient generator 206 will be described in detail below.

Subband divider 202 has a subband dividing filter that divides the input low-frequency bit stream into a plurality of real low-frequency subband signals in respective frequency bands, which are output to band expander 103 and subband combiner 104. The subband dividing filter used by subband divider 202 is provided by only a real number processor of the equation 102.2, and has its output signal serving as a real low-frequency subband signal. Therefore, since the low-frequency subband signal input to band expander 103 is represented by a real number, converter 305 outputs the real low-frequency subband signal that is input thereto, directly to high-frequency generator 300.

Corrective coefficient generator 206 calculates an energy corrective coefficient according to a predetermined process, and outputs the calculated energy corrective coefficient to energy corrector 105. Corrective coefficient generator 206 may calculate an energy corrective coefficient by generating a random number and using the random number as an energy corrective coefficient. The generated random number is normalized to a value ranging from 0 to 1. As described above with respect to the first embodiment, if the amplitude of the real high-frequency subband signal is adjusted such that its signal energy is equalized to the target energy, then the energy of high-frequency components of the decoded audio signal becomes greater than the target energy. However, the corrected target energy can be smaller than the target energy by using an energy corrective coefficient that is derived from a random number normalized to a value ranging from 0 to 1. As a result, since the energy of high-frequency components of the decoded audio signal is not necessarily greater than the target energy, a sound quality improving capability is expected. Alternatively energy corrective coefficients may be determined in advance for respective frequency bands, and an energy corrective coefficient may be generated depending on both or one of the frequency range of a subband from which a signal is to be copied and the frequency range of a subband to which the signal is to be copied by band expander 103. In this case, each of the predetermined energy corrective coefficients is also of a value ranging from 0 to 1. According to the present process, the human auditory characteristics can be better utilized for a greater sound quality improving capability than the process which calculates an energy corrective coefficient using a random number. The above two processes may be combined to determine a maximum value for a random number in each of the frequency bands and use a random number normalized in the range as an energy corrective coefficient. Alternatively, an average value may be determined in advance in each of the frequency bands, and a random number may be generated around the average value to calculate an energy corrective coefficient. Furthermore, an energy corrective coefficient is calculated for each of the divided frequency bands, and the energy corrective coefficients of adjacent frequency bands may be smoothed and used as the energy corrective coefficient of a certain frequency band. Alternatively, the energy corrective coefficient of a present frame may be smoothed in the time direction using a predetermined time constant and the energy corrective coefficient of a preceding frame,

According to the second embodiment of the present invention, since the signal phase of the low-frequency subband signal is not taken into account, the quality of the decoded audio signal is lower than with the first embodiment of the present invention. However, the second embodiment of the present invention can further reduce the amount of calculations required because there is no need for using the complex low-frequency subband and a real subband dividing filter can be used.

The present invention is not limited to the above embodiments, but those embodiments may be modified within the scope of the technical concept of the present invention.

Although not shown, the audio decoding apparatus according to the embodiments have a recording medium that stores a program for carrying out the audio decoding method described above, The recording medium may comprise a magnetic disk, a semiconductor memory, or another recording medium. The program is read from the recording medium into the audio decoding apparatus, and controls operation of the audio decoding apparatus. Specifically, a CPU in the audio decoding apparatus is controlled by the program to instruct hardware resources of the audio decoding apparatus to perform particular processes for carrying out the above processing sequences.

**Claims**

**1.** An audio decoding apparatus comprising:

a bit stream separator (100) for separating a bit stream into a low-frequency bit stream and a high-frequency bit stream; -

a low-frequency decoder (101) for decoding said low-frequency bit stream to generate a low-frequency audio signal;

a subband divider (202) for dividing said low-frequency audio signal into a plurality of real-valued signals in respective frequency bands to generate real-valued low-frequency subband signals;

a band expander (103) for generating real-valued copied subband signals by copying from said real-valued low-frequency subband signals using said high-frequency bit stream, and for generating real-valued high-frequency subband signals by adding said real-valued copied subband signals and an additional signal after correcting, in amplitude, the signal energies of said real-valued copied subband signals and said additional signal by using an energy corrective coefficient, wherein said energy corrective coefficient is adapted to convert a target energy of complex-valued high-frequency subband signals, included in said high-frequency bit stream, into a target energy of said real-valued high-frequency subband signals; and

a subband combiner (104) for combining said real-valued low-frequency subband signals and said real-valued high-frequency subband signals to produce a decoded audio signal.

2. An audio decoding apparatus according to claim 1, wherein the high-frequency bit stream contains copying information indicative of which one of the low-frequency subbands a real-valued low-frequency signal is to be copied from to generate a high-frequency subband, and signal processing information representing a signal processing process to be performed on the real-valued low-frequency signal.

3. An audio decoding apparatus according to claim 1 or 2, further comprising:

a corrective coefficient generator (206) for calculating said energy corrective coefficient; wherein said subband divider (202) further divides said low-frequency audio signal into a plurality of complex-valued low-frequency subband signals and wherein said corrective coefficient generator (206) calculates said energy corrective coefficient based on said complex-valued low-frequency subband signals.

4. An audio decoding apparatus according to claim 3, wherein said corrective coefficient generator (206) calculates the signal phase of said complex-valued low-frequency subband signals and calculates the energy corrective coefficient based on said signal phase.

5. An audio decoding apparatus according to claim 3, wherein said corrective coefficient generator (206) calculates the ratio of the energy of a real part of said complex-valued low-frequency subband signals to the signal energy of said low-frequency subband signals as said energy corrective coefficient.

6. An audio decoding apparatus according to claim 3, wherein said corrective coefficient generator (206) averages the phases of samples of said complex-valued low-frequency subband signals as said energy corrective coefficient.

7. An audio decoding apparatus according to any one of claims 3 to 6, wherein said corrective coefficient generator (206) smoothes said energy corrective coefficients calculated in respective frequency bands.

8. An audio decoding apparatus according to any one of claims 1 to 7, further comprising:

a corrective coefficient generator (206) for generating an energy corrective coefficient; and

an energy corrector (105) for calculating a corrected target energy by correcting a target energy of high-frequency subband signals included in said high-frequency bit stream, with said energy corrective coefficient.

9. An audio decoding apparatus according to claim 8, wherein said corrective coefficient generator (206) generates a random number and uses the random number as said energy corrective coefficient.

10. An audio decoding apparatus according to claim 8, wherein said corrective coefficient generator (206) generates said energy corrective coefficients in respective frequency bands.

11. An audio decoding method comprising the steps of:

separating a bit stream into a low-frequency bit stream and a high-frequency bit stream;
decoding said low-frequency bit stream to generate a low-frequency audio signal;

dividing said low-frequency audio signal into a plurality of real-valued signals in respective frequency bands to generate real-valued low-frequency subband signals;

generating real-valued copied subband signals by copying from said real-valued low-frequency subband signals using said high-frequency bit stream, and for generating real-valued high-frequency subband signals by adding said real-valued copied subband signals and an additional signal after correcting, in amplitude, the signal energies of said real-valued copied subband signals and said additional signal by using an energy corrective coefficient, wherein said energy corrective coefficient is adapted to convert a target energy of complex-valued high-frequency subband signals, included in said high-frequency bit stream, into a target energy of said real-valued high-frequency subband signals; and

combining said real-valued low-frequency subband signals and said real-valued high-frequency subband signals to produce a decoded audio signal.

12. An audio decoding method according to claim 11, wherein the high-frequency bit stream contains copying information indicative of which one of the low-frequency subbands a real-valued low-frequency signal is to be copied from to generate a high-frequency subband, and signal processing information representing a signal processing process to be performed on the real-valued low-frequency signal.

13. An audio decoding method according to claim 11 or 12 further comprising the steps of:

further dividing said low-frequency audio signal into a plurality of complex-valued law-frequency subband signals and calculating said energy corrective coefficient based on said complex-valued low-frequency subband signals.

14. An audio decoding method according to claim 13, wherein the signal phase of said complex-valued low-frequency subband signals is calculated, and the energy corrective coefficient is calculated based on said signal phase.

15. An audio decoding method according to claim 13, wherein the ratio of the energy of a real part of said complex-valued low-frequency subband signals to the signal energy of said low-frequency subband signals is calculated as said energy corrective coefficient.

16. An audio decoding method according to claim 13, wherein the phases of samples of said complex-valued low-frequency subband signals are averaged as said energy corrective coefficient.

17. An audio decoding method according to any one of claims 13 through 16, wherein energy corrective coefficients calculated in respective frequency bands are smoothed.

18. An audio decoding method according to any one of claims 11 to 17, further comprising the steps of:

generating an energy corrective coefficient; and
calculating a corrected target energy by correcting a target energy of high-frequency subband signals included in said high-frequency bit stream, with said energy corrective coefficient.

19. An audio decoding method according to claim 18, wherein for generating said energy corrective coefficient, a random number is generated and used as said energy corrective coefficient.

20. An audio decoding method according to claim 18, wherein for generating said energy corrective coefficient, said energy corrective coefficients are generated in respective frequency bands.

21. A program for enabling a computer to perform:

a bit stream separating process for separating a bit stream into a low-frequency bit stream and a high-frequency bit stream;

a low-frequency decoding process for decoding said low-frequency bit stream to generate a low-frequency audio signal; a subband dividing process for dividing said low-frequency audio signal into a plurality of real-valued signals in respective frequency bands to generate real-valued low frequency subband signals;

a band expanding process for generating real-valued copied subband signals by copying from said real-valued low-frequency subband signals using said high-frequency bit stream, and for generating real-valued high-frequency subband signals by adding said real-valued copied subband signals and an additional signal after correcting, in amplitude, the signal energies of said real-valued copied subband signals and an additional signal by using an energy corrective coefficient, wherein said energy corrective coefficient is adapted to convert a target energy of complex-valued high-frequency subband signals, included in said high-frequency bit stream, into a target energy of said real-valued high-frequency subband signals; and

a subband combining process for combining said real-valued low-frequency subband signals and said real-valued high-frequency subband signals to produce a decoded audio signal.

22. A program according to claim 21, wherein the high-frequency bit stream contains copying information indicative of which one of the low-frequency subbands a real-valued low-frequency signal is to be copied from to generate a high-frequency subband, and signal processing information representing a signal processing process to be performed on the real-valued low-frequency signal.

23. A program according to claim 21 or 22 further comprising a corrective coefficient generating process for calculating said energy corrective coefficient; wherein a complex subband dividing process further divides said low-frequency audio signal into a plurality of complex-valued low-frequency subband signals; and wherein said energy corrective coefficient generating process includes calculating said energy corrective coefficient based on said complex-valued low-frequency subband signals.

24. A program according to claim 23, wherein in said corrective coefficient generating process, the signal phase of said complex-valued low-frequency subband signals is calculated and the energy corrective coefficient is calculated based on said signal phase.

25. A program according to claim 23, wherein in said corrective coefficient generating process, the ratio of the energy of a real part of said low-frequency subband signals and the signal energy of said complex-valued low-frequency subband signals is calculated as said energy corrective coefficient.

26. A program according to claim 23, wherein in said corrective coefficient generating process, the phases of samples of said complex-valued low-frequency subband signals are averaged as said energy corrective coefficient.

27. A program according to any one of claims 23 through 26, wherein in said corrective coefficient generating process, said energy corrective coefficients calculated in respective frequency bands are smoothed.

28. A program according to any one of claims 21 to 27, further comprising:

a corrective coefficient generating process for generating an energy corrective coefficient; and

an energy correcting process for calculating a corrected target energy by correcting a target energy of high-frequency subband signals included in said high-frequency bit stream, with said energy corrective coefficient.

29. A program according to claim 28, wherein in said corrective coefficient generating process, a random number is generated and used as said energy corrective coefficient.

30. A program according to claim 28, wherein in said corrective coefficient generating process, said energy corrective coefficients are generated in respective frequency bands.

**Patentansprüche**

1. Audiodecodierungsvorrichtung mit:

einem Bitstromseparator (100) zum Teilen eines Bitstroms in einen Niederfrequenz-Bitstrom und einen Hochfrequenz-Bitstrom,

einem Niederfrequenz-Decodierer (101) zum Decodieren des Niederfrequenz-Bitstroms, um ein Niederfrequenz-Audiosignal zu erzeugen,

einem Unterbandteiler (202) zum Teilen des Niederfrequenz-Audiosignals in mehrere realwertige Signale in jeweiligen Frequenzbändern, um realwertige Niederfrequenz-Unterbandsignale zu erzeugen,

einem Band-Expander (103) zum Erzeugen realwertiger kopierter Unterbandsignale durch Kopieren von den realwertigen Niederfrequenz-Unterbandsignalen unter Verwendung des Hochfrequenz-Bitstroms und zum Erzeugen realwertiger Hochfrequenz-Unterbandsignale durch Addieren der realwertigen kopierten Unterbandsignale und eines zusätzlichen Signals, nachdem die Signalenergien der realwertigen kopierten Unterbandsignale

13

und des zusätzlichen Signals unter Verwendung eines Energiekorrekturkoeffizienten hinsichtlich der Amplitude korrigiert wurden, wobei der Energiekorrekturkoeffizient dafür geeignet ist, eine Sollenergie komplexwertiger Hochfrequenz-Unterbandsignale, die im Hochfrequenz-Bitstrom enthalten sind, in eine Sollenergie der realwertigen Hochfrequenz-Unterbandsignale umzuwandeln, und

einem Unterband-Kombinierer (104) zum Kombinieren der realwertigen Niederfrequenz-Unterbandsignale und der realwertigen Hochfrequenz-Unterbandsignale, um ein decodiertes Audiosignal zu erzeugen.

2. Audiodecodierungsvorrichtung nach Anspruch 1, wobei der Hochfrequenz-Bitstrom Kopierinformationen, welche angeben, von welchem der Niederfrequenz-Unterbänder ein realwertiges Niederfrequenzsignal zu kopieren ist, um ein Hochfrequenz-Unterband zu erzeugen, und Signalverarbeitungsinformationen, welche einen an dem realwertigen Niederfrequenzsignal auszuführenden Signalverarbeitungsprozess darstellen, enthält.

3. Audiodecodierungsvorrichtung nach Anspruch 1 oder 2, welche ferner aufweist:

einen Korrekturkoeffizientengenerator (206) zum Berechnen des Energiekorrekturkoeffizienten, wobei der Unterbandteiler (202) außerdem das Niederfrequenz-Audiosignal in mehrere komplexwertige Niederfrequenz-Unterbandsignale teilt und wobei der Korrekturkoeffizientengenerator (206) den Energiekorrekturkoeffizienten auf der Grundlage der komplexwertigen Niederfrequenz-Unterbandsignale berechnet.

4. Audiodecodierungsvorrichtung nach Anspruch 3, wobei der Korrekturkoeffizientengenerator (206) die Signalphase der komplexwertigen Niederfrequenz-Unterbandsignale berechnet und den Energiekorrekturkoeffizienten auf der Grundlage der Signalphase berechnet.

5. Audiodecodierungsvorrichtung nach Anspruch 3, wobei der Korrekturkoeffizientengenerator (206) das Verhältnis zwischen der Energie eines Realteils der komplexwertigen Niederfrequenz-Unterbandsignale und der Signalenergie der Niederfrequenz-Unterbandsignale als Energiekorrekturkoeffizient berechnet.

6. Audiodecodierungsvorrichtung nach Anspruch 3, wobei der Korrekturkoeffizientengenerator (206) die Phasen von Abtastwerten der komplexwertigen Niederfrequenz-Unterbandsignale als Energiekorrekturkoeffizient mittelt.

7. Audiodecodierungsvorrichtung nach einem der Ansprüche 3 bis 6, wobei der Korrekturkoeffizientengenerator (206) die in jeweiligen Frequenzbändern berechneten Energiekorrekturkoeffizienten glättet.

8. Audiodecodierungsvorrichtung nach einem der Ansprüche 1 bis 7, welche ferner aufweist:

einen Korrekturkoeffizientengenerator (206) zum Erzeugen eines Energiekorrekturkoeffizienten und eine Energiekorrektureinrichtung (105) zum Berechnen einer korrigierten Sollenergie durch Korrigieren einer Sollenergie von in dem Hochfrequenz-Bitstrom enthaltenen Hochfrequenz-Unterbandsignalen mit dem Energiekorrekturkoeffizienten.

9. Audiodecodierungsvorrichtung nach Anspruch 8, wobei der Korrekturkoeffizientengenerator (206) eine Zufallszahl erzeugt und die Zufallszahl als Energiekorrekturkoeffizienten verwendet.

10. Audiodecodierungsvorrichtung nach Anspruch 8, wobei der Korrekturkoeffizientengenerator (206) die Energiekorrekturkoeffizienten in jeweiligen Frequenzbändern erzeugt.

11. Audiodecodierungsverfahren mit den Schritten:

Teilen eines Bitstroms in einen Niederfrequenz-Bitstrom und einen Hochfrequenz-Bitstrom,
Decodieren des Niederfrequenz-Bitstroms zum Erzeugen eines Niederfrequenz-Audiosignals,
Teilen des Niederfrequenz-Audiosignals in mehrere realwertige Signale in jeweiligen Frequenzbändern zum Erzeugen realwertiger Niederfrequenz-Unterbandsignale,
Erzeugen realwertiger kopierter Unterbandsignale durch Kopieren von den realwertigen Niederfrequenz-Unterbandsignalen unter Verwendung des Hochfrequenz-Bitstroms und zum Erzeugen realwertiger Hochfrequenz-Unterbandsignale durch Addieren der realwertigen kopierten Unterbandsignale und eines zusätzlichen Signals, nachdem die Signalenergien der realwertigen kopierten Unterbandsignale und des zusätzlichen Signals unter Verwendung eines Energiekorrekturkoeffizienten hinsichtlich der Amplitude korrigiert wurden, wobei der Energiekorrekturkoeffizient dafür geeignet ist, eine Sollenergie komplexwertiger Hochfrequenz-Unterbandsignale, die im Hochfrequenz-Bitstrom enthalten sind, in eine Sollenergie der realwertigen Hochfrequenz-Unterbandsignale umzuwandeln, und

Kombinieren der realwertigen Niederfrequenz-Unterbandsignale und der realwertigen Hochfrequenz-Unterbandsignale zum Erzeugen eines decodierten Audiosignals.

12. Audiodecodierungsverfahren nach Anspruch 11, wobei der Hochfrequenz-Bitstrom Kopierinformationen, welche angeben, von welchem der Niederfrequenz-Unterbänder ein realwertiges Niederfrequenzsignal zu kopieren ist, um ein Hochfrequenz-Unterband zu erzeugen, und Signalverarbeitungsinformationen, welche einen an dem realwertigen Niederfrequenzsignal auszuführenden Signalverarbeitungsprozess darstellen, enthält.

13. Audiodecodierungsverfahren nach Anspruch 11 oder 12, welches ferner folgende Schritte aufweist:

weiteres Teilen des Niederfrequenz-Audiosignals in mehrere komplexwertige Niederfrequenz-Unterbandsignale und

Berechnen des Energiekorrekturkoeffizienten auf der Grundlage der komplexwertigen Niederfrequenz-Unterbandsignale.

14. Audiodecodierungsverfahren nach Anspruch 13, wobei die Signalphase der komplexwertigen Niederfrequenz-Unterbandsignale berechnet wird und der Energiekorrekturkoeffizient auf der Grundlage der Signalphase berechnet wird.

15. Audiodecodierungsverfahren nach Anspruch 13, wobei das Verhältnis zwischen der Energie eines Realteils der komplexwertigen Niederfrequenz-Unterbandsignale und der Signalenergie der Niederfrequenz-Unterbandsignale als Energiekorrekturkoeffizient berechnet wird.

16. Audiodecodierungsverfahren nach Anspruch 13, wobei die Phasen von Abtastwerten der komplexwertigen Niederfrequenz-Unterbandsignale als Energiekorrekturkoeffizient gemittelt werden.

17. Audiodecodierungsverfahren nach einem der Ansprüche 13 bis 16, wobei die in den jeweiligen Frequenzbändern berechneten Energiekorrekturkoeffizienten geglättet werden.

18. Audiodecodierungsverfahren nach einem der Ansprüche 11 bis 17, welches ferner folgende Schritte aufweist:

Erzeugen eines Energiekorrekturkoeffizienten und

Berechnen einer korrigierten Sollenergie durch Korrigieren einer Sollenergie von in dem Hochfrequenz-Bitstrom enthaltenen Hochfrequenz-Unterbandsignalen mit dem Energiekorrekturkoeffizienten.

19. Audiodecodierungsverfahren nach Anspruch 18, wobei zum Erzeugen des Energiekorrekturkoeffizienten eine Zufallszahl erzeugt und als Energiekorrekturkoeffizient verwendet wird.

20. Audiodecodierungsverfahren nach Anspruch 18, wobei zum Erzeugen des Energiekorrekturkoeffizienten die Energiekorrekturkoeffizienten in jeweiligen Frequenzbändern erzeugt werden.

21. Programm, das es einem Computer ermöglicht, die folgenden Verarbeitungen auszuführen:

eine Bitstrom-Trennverarbeitung zum Teilen eines Bitstroms in einen Niederfrequenz-Bitstrom und einen Hochfrequenz-Bitstrom,

eine Niederfrequenz-Decodierungsverarbeitung zum Decodieren des Niederfrequenz-Bitstroms, um ein Niederfrequenz-Audiosignal zu erzeugen,

eine Unterband-Teilungsverarbeitung zum Teilen des Niederfrequenz-Audiosignals in mehrere realwertige Signale in jeweiligen Frequenzbändern, um realwertige Niederfrequenz-Unterbandsignale zu erzeugen,

eine Bandexpansionsverarbeitung zum Erzeugen realwertiger kopierter Unterbandsignale durch Kopieren von den realwertigen Niederfrequenz-Unterbandsignalen unter Verwendung des Hochfrequenz-Bitstroms und zum Erzeugen realwertiger Hochfrequenz-Unterbandsignale durch Addieren der realwertigen kopierten Unterbandsignale und eines zusätzlichen Signals, nachdem die Signalenergien der realwertigen kopierten Unterbandsignale und eines zusätzlichen Signals unter Verwendung eines Energiekorrekturkoeffizienten hinsichtlich der Amplitude korrigiert wurden,

wobei der Energiekorrekturkoeffizient dafür geeignet ist, eine Sollenergie komplexwertiger Hochfrequenz-Unterbandsignale, die im Hochfrequenz-Bitstrom enthalten sind, in eine Sollenergie der realwertigen Hochfrequenz-Unterbandsignale umzuwandeln, und

eine Unterband-Kombinierverarbeitung zum Kombinieren der realwertigen Niederfrequenz-Unterbandsignale und der realwertigen Hochfrequenz-Unterbandsignale, um ein decodiertes Audiosignal zu erzeugen.

22. Programm nach Anspruch 21, wobei der Hochfrequenz-Bitstrom Kopierinformationen, welche angeben, von welchem der Niederfrequenz-Unterbänder ein realwertiges Niederfrequenzsignal zu kopieren ist, um ein Hochfrequenz-Unterband zu erzeugen, und Signalverarbeitungsinformationen, welche einen an dem realwertigen Niederfrequenzsignal auszuführenden Signalverarbeitungsprozess darstellen, enthält.

23. Programm nach Anspruch 21 oder 22, welches ferner eine Korrekturkoeffizienten-Erzeugungsverarbeitung zum Berechnen des Energiekorrekturkoeffizienten aufweist, wobei eine Verarbeitung zum Teilen eines komplexen Unterbands ferner das Niederfrequenz-Audiosignal in mehrere komplexwertige Niederfrequenz-Unterbandsignale teilt und wobei bei der Energiekorrekturkoeffizienten-Erzeugungsverarbeitung der Energiekorrekturkoeffizient auf der Grundlage der komplexwertigen Niederfrequenz-Unterbandsignale berechnet wird.

24. Programm nach Anspruch 23, wobei bei der Korrekturkoeffizienten-Erzeugungsverarbeitung die Signalphase der komplexwertigen Niederfrequenz-Unterbandsignale berechnet wird und der Energiekorrekturkoeffizient auf der Grundlage der Signalphase berechnet wird.

25. Programm nach Anspruch 23, wobei bei der Korrekturkoeffizienten-Erzeugungsverarbeitung das Verhältnis zwischen der Energie eines Realteils der Niederfrequenz-Unterbandsignale und der Signalenergie der komplexwertigen Niederfrequenz-Unterbandsignale als Energiekorrekturkoeffizient berechnet wird.

26. Programm nach Anspruch 23, wobei bei der Korrekturkoeffizienten-Erzeugungsverarbeitung die Phasen von Abtastwerten der komplexwertigen Niederfrequenz-Unterbandsignale als Energiekorrekturkoeffizient gemittelt werden.

27. Programm nach einem der Ansprüche 23 bis 26, wobei bei der Korrekturkoeffizienten-Erzeugungsverarbeitung die in jeweiligen Frequenzbändern berechneten Energiekorrekturkoeffizienten geglättet werden.

28. Programm nach einem der Ansprüche 21 bis 27, welches ferner aufweist:

eine Korrekturkoeffizienten-Erzeugungsverarbeitung zum Erzeugen eines Energiekorrekturkoeffizienten und eine Energiekorrekturverarbeitung zum Berechnen einer korrigierten Sollenergie durch Korrigieren einer Sollenergie von in dem Hochfrequenz-Bitstrom enthaltenen Hochfrequenz-Unterbandsignalen mit dem Energiekorrekturkoeffizienten.

29. Programm nach Anspruch 28, wobei bei der Korrekturkoeffizienten-Erzeugungsverarbeitung eine Zufallszahl erzeugt wird und als Energiekorrekturkoeffizient verwendet wird.

30. Programm nach Anspruch 28, wobei bei der Korrekturkoeffizienten-Erzeugungsverarbeitung die Energiekorrekturkoeffizienten in jeweiligen Frequenzbändern erzeugt werden.

**Revendications**

1. Dispositif de décodage audio, comprenant :

un séparateur de train de bits (100) destiné à séparer un train de bits en un train de bits à basse fréquence et un train de bits à haute fréquence ;
un décodeur à basse fréquence (101) destiné à décoder ledit train de bits à basse fréquence afin de générer un signal audio à basse fréquence ;
un diviseur de sous-bande (202) destiné à diviser ledit signal audio à basse fréquence en une pluralité de signaux à valeurs réelles dans des bandes de fréquences respectives afin de générer des signaux de sous-bande à basse fréquence à valeurs réelles ;
un développeur de bande (103) destiné à générer des signaux de sous-bande copiés à valeurs réelles par copie à partir desdits signaux de sous-bande à basse fréquence à valeurs réelles en utilisant ledit train de bits à haute fréquence, et à générer des signaux de sous-bande à haute fréquence à valeurs réelles en ajoutant lesdits signaux de sous-bande copiés à valeurs réelles et un signal supplémentaire après avoir corrigé, en amplitude, les énergies de signal desdits signaux de sous-bande copiés à valeurs réelles et ledit signal supplémentaire en utilisant un coefficient correcteur d'énergie, dans lequel ledit coefficient correcteur d'énergie est conçu pour convertir une énergie cible de signaux de sous-bande à haute fréquence à valeurs complexes, inclus dans ledit train de bits à haute fréquence, en une énergie cible desdits signaux de sous-bande à haute fréquence à valeurs réelles ; et

un mélangeur de sous-bandes (104) destiné à mélanger lesdits signaux de sous-bande à basse fréquence à valeurs réelles et lesdits signaux de sous-bande à haute fréquence à valeurs réelles afin de produire un signal audio décodé.

2. Dispositif de décodage audio selon la revendication 1, dans lequel le train de bits à haute fréquence contient des informations de copie indicatives de celle des sous-bandes à basse fréquence à partir de laquelle un signal à basse fréquence à valeurs réelles doit être copié pour générer une sous-bande à haute fréquence, et des informations de traitement de signal représentant un processus de traitement de signal devant être exécuté sur le signal à basse fréquence à valeurs réelles.

3. Dispositif de décodage audio selon la revendication 1 ou 2, comprenant en outre :

un générateur de coefficient correcteur (206) destiné à calculer ledit coefficient correcteur d'énergie ; dans lequel ledit diviseur de sous-bande (202) divise, en outre, ledit signal audio à basse fréquence en une pluralité de signaux de sous-bande à basse fréquence à valeurs complexes et dans lequel ledit générateur de coefficient correcteur (206) calcule ledit coefficient correcteur d'énergie sur la base desdits signaux de sous-bande à basse fréquence à valeurs complexes.

4. Dispositif de décodage audio selon la revendication 3, dans lequel ledit générateur de coefficient correcteur (206) calcule la phase de signal desdits signaux de sous-bande à basse fréquence à valeurs complexes et calcule le coefficient correcteur d'énergie sur la base de ladite phase de signal.

5. Dispositif de décodage audio selon la revendication 3, dans lequel ledit générateur de coefficient correcteur (206) calcule le rapport de l'énergie d'une partie réelle desdits signaux de sous-bande à basse fréquence à valeurs complexes à l'énergie de signal desdits signaux de sous-bande à basse fréquence en tant que ledit coefficient correcteur d'énergie.

6. Dispositif de décodage audio selon la revendication 3, dans lequel ledit générateur de coefficient correcteur (206) fait la moyenne des phases d'échantillons desdits signaux de sous-bande à basse fréquence à valeurs complexes en tant que ledit coefficient correcteur d'énergie.

7. Dispositif de décodage audio selon l'une quelconque des revendications 3 à 6, dans lequel ledit générateur de coefficient correcteur (206) lisse lesdits coefficients correcteurs d'énergie calculés dans des bandes de fréquences respectives.

8. Dispositif de décodage audio selon l'une quelconque des revendications 1 à 7, comprenant en outre :

un générateur de coefficient correcteur (206) destiné à générer un coefficient correcteur d'énergie ; et
un correcteur d'énergie (105) destiné à calculer une énergie cible corrigée en corrigeant une énergie cible de signaux de sous-bande à haute fréquence inclus dans ledit train de bits à haute fréquence, avec ledit coefficient correcteur d'énergie.

9. Dispositif de décodage audio selon la revendication 8, dans lequel ledit générateur de coefficient correcteur (206) génère un nombre aléatoire et utilise le nombre aléatoire en tant que ledit coefficient correcteur d'énergie.

10. Dispositif de décodage audio selon la revendication 8, dans lequel ledit générateur de coefficient correcteur (206) génère lesdits coefficients correcteurs d'énergie dans des bandes de fréquences respectives.

11. Procédé de décodage audio, comprenant les étapes suivantes :

la séparation d'un train de bits en un train de bits à basse fréquence et un train de bits à haute fréquence ;
le décodage dudit train de bits à basse fréquence afin de générer un signal audio à basse fréquence ;

la division dudit signal audio à basse fréquence en une pluralité de signaux à valeurs réelles dans des bandes de fréquences respectives afin de générer des signaux de sous-bande à basse fréquence à valeurs réelles ;

la génération de signaux de sous-bande copiés à valeurs réelles par copie à partir desdits signaux de sous-bande à basse fréquence à valeurs réelles en utilisant ledit train de bits à haute fréquence, et la génération de signaux de sous-bande à haute fréquence à valeurs réelles en ajoutant lesdits signaux de sous-bande copiés à valeurs réelles et un signal supplémentaire après avoir corrigé, en amplitude, les énergies de signal desdits signaux de sous-bande copiés à valeurs réelles et ledit signal supplémentaire en utilisant un coefficient correcteur d'énergie, dans lequel ledit coefficient correcteur d'énergie est conçu pour convertir une énergie cible de signaux de sous-bande à haute fréquence à valeurs complexes, inclus dans ledit train de bits à haute fréquence, en une énergie cible desdits signaux de sous-bande à haute fréquence à valeurs réelles ; et

le mélange desdits signaux de sous-bande à basse fréquence à valeurs réelles et desdits signaux de sous-bande à haute fréquence à valeurs réelles afin de produire un signal audio décodé.

**12.** Procédé de décodage audio selon la revendication 11, dans lequel le train de bits à haute fréquence contient des informations de copie indicatives de celle des sous-bandes à basse fréquence à partir de laquelle un signal à basse fréquence à valeurs réelles doit être copié pour générer une sous-bande à haute fréquence, et des informations de traitement de signal représentant un processus de traitement de signal devant être exécuté sur le signal à basse fréquence à valeurs réelles.

**13.** Procédé de décodage audio selon la revendication 11 ou 12, comprenant, en outre, les étapes suivantes :

la division, en outre, dudit signal audio à basse fréquence en une pluralité de signaux de sous-bande à basse fréquence à valeurs complexes, et le calcul dudit coefficient correcteur d'énergie sur la base desdits signaux de sous-bande à basse fréquence à valeurs complexes.

**14.** Procédé de décodage audio selon la revendication 13, dans lequel la phase de signal desdits signaux de sous-bande à basse fréquence à valeurs complexes est calculée, et le coefficient correcteur d'énergie est calculé sur la base de ladite phase de signal.

**15.** Procédé de décodage audio selon la revendication 13, dans lequel le rapport de l'énergie d'une partie réelle desdits signaux de sous-bande à basse fréquence à valeurs complexes à l'énergie de signal desdits signaux de sous-bande à basse fréquence est calculé en tant que ledit coefficient correcteur d'énergie.

**16.** Procédé de décodage audio selon la revendication 13, dans lequel on établit la moyenne des phases d'échantillons desdits signaux de sous-bande à basse fréquence à valeurs complexes en tant que ledit coefficient correcteur d'énergie.

**17.** Procédé de décodage audio selon l'une quelconque des revendications 13 à 16, dans lequel lesdits coefficients correcteurs d'énergie calculés dans des bandes de fréquences respectives sont lissés.

**18.** Procédé de décodage audio selon l'une quelconque des revendications 11 à 17, comprenant, en outre les étapes suivantes :

la génération d'un coefficient correcteur d'énergie ; et

le calcul d'une énergie cible corrigée en corrigeant une énergie cible de signaux de sous-bande à haute fréquence inclus dans ledit train de bits à haute fréquence, avec ledit coefficient correcteur d'énergie.

**19.** Procédé de décodage audio selon la revendication 18, dans lequel pour générer ledit coefficient correcteur d'énergie, un nombre aléatoire est généré et utilisé en tant que ledit coefficient correcteur d'énergie.

**20.** Procédé de décodage audio selon la revendication 18, dans lequel pour générer ledit coefficient correcteur d'énergie, lesdits coefficients correcteurs d'énergie sont générés dans des bandes de fréquences respectives.

**21.** Programme permettant à un ordinateur d'exécuter :

un processus de séparation de train de bits pour séparer un train de bits en un train de bits à basse fréquence et un train de bits à haute fréquence ;

un processus de décodage à basse fréquence pour décoder ledit train de bits à basse fréquence afin de générer un signal audio à basse fréquence ;

un processus de division de sous-bande pour diviser ledit signal audio à basse fréquence en une pluralité de signaux à valeurs réelles dans des bandes de fréquences respectives afin de générer des signaux de sous-bande à basse fréquence à valeurs réelles ;

un processus de développement de bande pour générer des signaux de sous-bande copiés à valeurs réelles par copie à partir desdits signaux de sous-bande à basse fréquence à valeurs réelles en utilisant ledit train de bits à haute fréquence, et pour générer les signaux de sous-bande à haute fréquence à valeurs réelles en ajoutant lesdits signaux de sous-bande copiés à valeurs réelles et un signal supplémentaire après avoir corrigé, en amplitude, les énergies de signal desdits signaux de sous-bande copiés à valeurs réelles et un signal supplémentaire en utilisant un coefficient correcteur d'énergie, dans lequel ledit coefficient correcteur d'énergie est conçu pour convertir une énergie cible de signaux de sous-bande à haute fréquence à valeurs complexes, inclus dans ledit train de bits à haute fréquence, en une énergie cible desdits signaux de sous-bande à haute fréquence à valeurs réelles ; et

un processus de mélange de sous-bandes pour mélanger lesdits signaux de sous-bande à basse fréquence à valeurs réelles et lesdits signaux de sous-bande à haute fréquence à valeurs réelles afin de produire un signal audio décodé.

22. Programme selon la revendication 21, dans lequel le train de bits à haute fréquence contient des informations de copie indicatives de celle des sous-bandes à basse fréquence à partir de laquelle un signal à basse fréquence à valeurs réelles doit être copié pour générer une sous-bande à haute fréquence, et des informations de traitement de signal représentant un processus de traitement de signal devant être exécuté sur le signal à basse fréquence à valeurs réelles.

23. Programme selon la revendication 21 ou 22, comprenant en outre un processus de génération de coefficient correcteur pour calculer ledit coefficient correcteur d'énergie ; dans lequel un processus de division de sous-bande complexe divise, en outre, ledit signal audio à basse fréquence en une pluralité de signaux de sous-bande à basse fréquence à valeurs complexes ; et dans lequel ledit processus de génération de coefficient correcteur d'énergie inclut le calcul dudit coefficient correcteur d'énergie sur la base desdits signaux de sous-bande à basse fréquence à valeurs complexes.

24. Programme selon la revendication 23, dans lequel, dans ledit processus de génération de coefficient correcteur, la phase de signal desdits signaux de sous-bande à basse fréquence à valeurs complexes est calculée et le coefficient correcteur d'énergie est calculé sur la base de ladite phase de signal.

25. Programme selon la revendication 23, dans lequel, dans ledit processus de génération de coefficient correcteur, le rapport de l'énergie d'une partie réelle desdits signaux de sous-bande à basse fréquence et l'énergie de signal desdits signaux de sous-bande à basse fréquence à valeurs complexes est calculé en tant que ledit coefficient correcteur d'énergie.

26. Programme selon la revendication 23, dans lequel dans ledit processus de génération de coefficient correcteur, on établit la moyenne des phases d'échantillons desdits signaux de sous-bande à basse fréquence à valeurs complexes en tant que ledit coefficient correcteur d'énergie.

27. Programme selon l'une quelconque des revendications 23 à 26, dans lequel, dans ledit processus de génération de coefficient correcteur, lesdits coefficients correcteurs d'énergie calculés dans des bandes de fréquences respectives sont lissés.

28. Programme selon l'une quelconque des revendications 21 à 27, comprenant en outre :

un processus de génération de coefficient correcteur pour générer un coefficient correcteur d'énergie ; et

un processus de correction d'énergie pour calculer une énergie cible corrigée en corrigeant une énergie cible de signaux de sous-bande à haute fréquence inclus dans ledit train de bits à haute fréquence, avec ledit coefficient correcteur d'énergie.

29. Programme selon la revendication 28, dans lequel, dans ledit processus de génération de coefficient correcteur, un nombre aléatoire est généré et utilisé en tant que ledit coefficient correcteur d'énergie.

30. Programme selon la revendication 28, dans lequel, dans ledit processus de génération de coefficient correcteur, lesdits coefficients correcteurs d'énergie sont générés dans des bandes de fréquences respectives.

Fig. 1

EP 2 019 391 B1

# Fig. 2



complex band expander — 403

502 ○

500 high-frequency generator

501 complex amplitude adjuster — ○ 503

504 ○

EP 2 019 391 B1

# F i g. 3

**Fig. 3**

EP 2 019 391 B1

EP 2 019 391 B1

# Fig. 4

complex part

corrected target energy

target energy

Phase B

high-frequency
components of the
input signal

Phase A

real part

real part of high-frequency
components after the
amplitude is adjusted

real part of
high-frequency
components
generated from
low-frequency components

Fig. 5

EP 2 019 391 B1

Fig. 7

EP 2 019 391 B1

# Fig. 8

band expander

302 ○

103

301

305

300

converter → high-frequency generator → amplitude adjuster

→ ○ 303

○ 304

○ 306

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- EP 0940015 A
- US 20020087304 A1

- WO 03046891 A1

**Non-patent literature cited in the description**

- Digital Radio Mondiale (DRM); System Specification. *ETSI TS 101 980 V1. 1.1,* September 2001, 42-57